(19) Europäisches Patentamt
European Patent Office
Office européen des brevets

(11) **EP 2 758 976 B1**

(12) **FASCICULE DE BREVET EUROPEEN**

(45) Date de publication et mention de la délivrance du brevet:
**13.06.2018 Bulletin 2018/24**

(21) Numéro de dépôt: **12759777.1**

(22) Date de dépôt: **21.09.2012**

(51) Int Cl.:
*H01H 33/22* (2006.01)    *C09K 3/30* (2006.01)
*H02B 13/055* (2006.01)

(86) Numéro de dépôt international:
**PCT/EP2012/068686**

(87) Numéro de publication internationale:
**WO 2013/041695 (28.03.2013 Gazette 2013/13)**

(54) **MÉLANGE D'HYDROFLUOROOLÉFINE ET DE FLUOROCÉTONE POUR L'UTILISATION COMME MILIEU D'ISOLATION ET/OU D'EXTINCTION D'ARC ET APPAREIL ÉLECTRIQUE MOYENNE TENSION A ISOLATION GAZEUSE LE COMPRENANT**

MISCHUNG AUS HYDROFLUOROLEFIN UND FLUOROKETON ZUR VERWENDUNG ALS ISOLIER- UND/ODER LICHTBOGENLÖSCHMEDIUM UND GASISOLIERTE ELEKTRISCHE MITTELSPANNUNGSVORRICHTUNG DAMIT

MIXTURE OF HYDROFLUOROOLEFIN AND FLUOROKETONE FOR USE AS AN INSULATION AND/OR ARC-EXTINGUISHING MEDIUM AND A GAS INSULATED MEDIUM-VOLTAGE ELECTRICAL DEVICE COMPRISING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.09.2011 FR 1158456**

(43) Date de publication de la demande:
**30.07.2014 Bulletin 2014/31**

(73) Titulaire: **Schneider Electric Industries SAS**
**92500 Rueil-Malmaison (FR)**

(72) Inventeurs:
• **KIEFFEL, Yannick**
**38440 Saint Jean De Bournay (FR)**
• **GIRODET, Alain**
**69680 Chassieu (FR)**
• **PICCOZ, Daniel**
**69480 Lucenay (FR)**
• **MALADEN, Romain**
**38050 Grenoble Cedex 9 (FR)**

(74) Mandataire: **Ahner, Philippe et al**
**BREVALEX**
**95, rue d'Amsterdam**
**75378 Paris Cedex 8 (FR)**

(56) Documents cités:
DE-U1-202009 009 305    DE-U1-202009 018 239
US-A1- 2010 123 095    US-B2- 7 655 610

**Description**

**DOMAINE TECHNIQUE**

La présente invention se rapporte au domaine de l'isolation électrique et de l'extinction des arcs électriques dans des appareils moyenne tension.

Plus précisément, elle se rapporte à l'utilisation d'un mélange comprenant un alcène particulier, à savoir une hydrofluorooléfine à trois atomes de carbone, et un gaz vecteur à base d'une fluorocétone, à savoir la décafluoro-2-méthylbutan-3-one, en tant que milieu d'isolation et/ou d'extinction d'arc dans des appareils électriques de sous-station et, en particulier, dans des appareils moyenne tension. Le mélange peut comprendre d'autres gaz dont le potentiel de réchauffement global est inférieur, notamment inférieur ou égal à un.

Elle se rapporte également à des appareils électriques de sous-station de moyenne tension dans lesquels l'isolation électrique et/ou l'extinction d'arc électrique sont assurées par un mélange gazeux comprenant au moins une fluorocétone et une hydrofluorooléfine, ce dernier composé présentant le plus fort potentiel de réchauffement global dans le milieu gazeux.

Un tel appareil électrique peut notamment être un transformateur électrique tel qu'un transformateur d'alimentation ou de mesure, une ligne à isolation gazeuse pour le transport ou la distribution de l'électricité, un jeu de barres ou encore un appareil électrique de connexion/déconnexion (aussi appelé appareil de coupure) tel qu'un disjoncteur, un interrupteur, un combiné interrupteur-fusibles, un sectionneur, un sectionneur de mise à la terre ou un contacteur.

**ETAT DE LA TECHNIQUE ANTÉRIEURE**

Dans ce qui précède et ce qui suit, les termes « moyenne tension » (MT) et « haute tension » (HT) sont utilisés dans leur acceptation habituelle, à savoir que le terme « moyenne tension » désigne une tension qui est supérieure à 1 000 volts en courant alternatif et à 1500 volts en courant continu mais qui ne dépasse pas 52 000 volts en courant alternatif et 75 000 volts en courant continu, tandis que le terme « haute tension » désigne une tension qui est strictement supérieure à 52 000 volts en courant alternatif et à 75 000 volts en courant continu.

Dans les appareils électriques moyenne ou haute tension, l'isolation électrique et, le cas échéant, l'extinction des arcs électriques sont typiquement assurées par un gaz qui est confiné à l'intérieur d'une enceinte de ces appareils. Actuellement, le gaz le plus souvent utilisé est l'hexafluorure de soufre ($SF_6$) : ce gaz présente une rigidité diélectrique relativement haute, une bonne conductivité thermique et des pertes diélectriques peu élevées. Il est chimiquement inerte et non toxique pour l'homme et les animaux et, après avoir été dissocié par un arc électrique, il se recombine rapidement et presque totalement. De plus, il est ininflammable et son prix est, encore aujourd'hui, modéré.

Toutefois, le $SF_6$ a pour inconvénient majeur de présenter un potentiel de réchauffement global (PRG) de 22 800 (relativement au $CO_2$ sur 100 ans) et une durée de séjour dans l'atmosphère de 3 200 ans, ce qui le place parmi les gaz à fort pouvoir d'effet de serre. Le $SF_6$ a donc été inscrit par le Protocole de Kyoto (1997) sur la liste des gaz dont les émissions doivent être limitées.

Le meilleur moyen de limiter les émissions du $SF_6$ consiste à limiter l'utilisation de ce gaz, ce qui a conduit les industriels à chercher des alternatives au $SF_6$. De fait, les autres solutions comme les systèmes hybrides associant une isolation gazeuse à une isolation solide (EP 1 724 802 - référence [1]) augmentent le volume des appareils électriques par rapport à celui qu'autorise une isolation au $SF_6$; la coupure dans l'huile ou le vide nécessite une refonte des appareillages.

Des gaz diélectriques sont connus : voir par exemple WO 2008/073790 (référence [2]). Cependant, les gaz dits simples comme l'air ou l'azote, qui n'ont pas d'impact négatif sur l'environnement, présentent une rigidité diélectrique beaucoup plus faible que celle du $SF_6$; leur utilisation pour l'isolation électrique et/ou l'extinction des arcs électriques dans des appareils HT/MT implique d'augmenter de façon drastique le volume et/ou la pression de remplissage de ces appareils, ce qui va à l'encontre des efforts qui ont été réalisés au cours de ces dernières décennies pour développer des appareils électriques compacts, à encombrement de plus en plus réduit.

Les perfluorocarbones ($C_nF_{2n+2}$, c-$C_4F_8$) présentent, d'une manière générale, des propriétés de tenue diélectrique intéressantes, mais leur PRG s'inscrit typiquement dans une gamme allant de 5 000 à 10 000. D'autres alternatives prometteuses d'un point de vue caractéristiques électriques et PRG, comme le trifluoroiodométhane ($CF_3I$), sont classées parmi les substances cancérigènes, mutagènes et reprotoxiques de catégorie 3, ce qui est rédhibitoire pour une utilisation à une échelle industrielle.

Des mélanges de $SF_6$ et d'autres gaz comme l'azote ou le dioxyde d'azote sont utilisés pour limiter l'impact du $SF_6$ sur l'environnement : voir, par exemple, WO 2009/049144 (référence [3]). Néanmoins, du fait du fort PRG du $SF_6$, le PRG de ces mélanges reste très élevé. Ainsi, par exemple, un mélange de $SF_6$ et d'azote dans un rapport volumique de 10/90 présente une rigidité diélectrique en tension alternative (50 Hz) égale à 59 % de celle du $SF_6$ mais son PRG est de l'ordre de 8 000 à 8 650. De tels mélanges ne sauraient donc être utilisés comme gaz à faible impact environnemental.

Ainsi donc, seuls les mélanges à PRG important permettent une tenue diélectrique proche de celle du $SF_6$ à basse température ; tous les mélanges à faible PRG proposés dans l'art antérieur permettent d'atteindre au maximum 80 % des performances des appareils $SF_6$ pour les températures d'utilisation les plus basses ; pour s'approcher des performances du $SF_6$, ces mélanges ga-

zeux nécessitent une nouvelle conception des appareillages MT et/ou HT en prenant des distances d'isolation supérieures et en ajoutant éventuellement des artifices comme des écrans, déflecteurs ou gainages.

Enfin, il a été proposé dans le modèle d'utilité DE 20 2009 009 305 U1, **[4],** d'utiliser une fluorocétone telle que la décafluoro-2-méthylbutan-3-one, seule ou en mélange avec un autre composant, comme milieu de remplissage d'un commutateur de moyenne ou haute tension pour y assurer une isolation électrique et une extinction des arcs électriques. Toutefois, ce document est muet sur les performances susceptibles d'être réellement obtenues, en termes d'isolation électrique et d'extinction des arcs électriques, avec ce type de milieu de remplissage.

Aussi les Inventeurs se sont-ils fixé pour but de trouver un gaz qui, tout en ayant de bonnes propriétés d'isolation électrique et d'extinction des arcs électriques, ait un impact sur l'environnement faible ou nul. Les recherches les ont menés à envisager un nouveau mélange de gaz qui puisse être utilisé dans les appareils électriques moyenne ou haute tension qui sont actuellement commercialisés, en lieu et place du $SF_6$ dont sont généralement remplis ces appareils, et ce sur toute la gamme de leurs températures d'utilisation, notamment à basses températures.

## EXPOSÉ DE L'INVENTION

Ces buts et d'autres encore sont atteints par l'invention qui propose, en premier lieu, l'utilisation d'un milieu gazeux comprenant au moins une hydrofluorooléfine et une fluorocétone comme milieu d'isolation électrique et/ou d'extinction des arcs électriques dans un appareil moyenne tension.

Les fluorocétones utilisées sont des cétones de chaîne carbonée à cinq atomes de carbone, de préférence totalement substituées par du fluor et, mieux encore, de type décafluoro-2-méthylbutan-3-one, qui ne sont pas toxiques, pas corrosives, pas explosives, qui se dégradent très rapidement dans l'atmosphère en raison de la sensibilité aux ultraviolets que présente la double liaison du groupe cétone -C=O et ont donc un PRG proche de 1.

Les hydrofluorooléfines utilisées sont des alcènes fluorés de chaîne carbonée à trois atomes de carbone, de préférence de type $C_3H_2F_4$ ou $C_3HF_5$, qui ne sont pas toxiques, pas corrosifs, pas explosifs, ont un potentiel de destruction de l'ozone ODP (« *Ozone Depletion Potential* » selon la terminologie anglosaxonne) de 0, un PRG inférieur à 10.

Ces deux types de composé sont dotés de propriétés diélectriques aptes à leur faire remplacer le $SF_6$ comme gaz d'isolation et/ou d'extinction d'arc dans les appareils électriques de sous-station de moyenne tension.

Conformément à l'invention, le mélange est tel que ses composants sont maintenus à l'état de gaz dans les conditions de température et de pression auxquelles il est destiné à être soumis une fois confiné dans l'appareil électrique. Le mélange entre fluorocétone et hydrofluoro-oléfine peut être ainsi utilisé seul ; toutefois, le mélange sera le plus souvent dilué avec au moins un autre gaz qui n'appartient pas à leurs familles, si la température d'ébullition ne permet pas de garantir son maintien à l'état gazeux à une pression totale suffisante pour certaines applications qui, par exemple, peuvent demander plus de $10^5$ Pascals (Pa).

Dans ce cas, selon l'invention, les autres gaz utilisés dans le milieu gazeux ont un potentiel de réchauffement global inférieur à celui des hydrofluorooléfines ; le gaz vecteur, ou gaz de dilution, ou gaz tampon, présente de préférence une température d'ébullition très basse, c'est-à-dire typiquement égale ou inférieure à -50°C à la pression standard, et une rigidité diélectrique qui est au moins égale à celle que présente l'azote ou le dioxyde de carbone. De préférence, le mélange comprend un gaz de type azote, air, avantageusement air sec, oxygène, dioxyde de carbone, ou un mélange de ces gaz. Le PRG global du milieu gazeux est en rapport des pressions partielles de chacun de ses composants, et donc inférieur à 10, et de préférence inférieur à 5.

Avantageusement, de manière à mettre la quantité maximale de chacun des gaz sans générer de phase liquide à la température minimale d'utilisation de l'appareil, la composition du milieu gazeux sera définie selon la loi de Raoult pour la température minimale d'utilisation de l'appareil, voire pour une température légèrement supérieure à cette dernière, notamment de 3°C. en particulier, pour un mélange ternaire fluorocétone (FK)/hydrofluorooléfine (HFO)/ gaz de dilution, les pressions de chaque constituant seront donc définies par :

$$P_{totale} = \frac{P_{HFO} + P_{FK}}{\dfrac{P_{HFO}}{PVS_{HFO}} + \dfrac{P_{FK}}{PVS_{FK}}} + P_{gazdilution}, \text{ avec}$$

PVS = pression de vapeur saturante du gaz concerné. Ainsi, les propriétés diélectriques du milieu gazeux en ligne directe et en cheminement sont les plus élevées possibles et se rapprochent au mieux de celles du $SF_6$.

Dans les modes de réalisation préférés, la température minimale d'utilisation $T_{min}$ est choisie parmi : 0, -5, -10, -15, -20, -25, -30, -35, et -40°C. Avantageusement, la pression partielle de fluorocétone est comprise entre 80 et 120 hPa, notamment pour une température minimale d'utilisation de -25°C, avec complément en HFO et $N_2$ selon la loi de Raoult appliquée à -22°C.

L'invention a également pour objet un appareil électrique de moyenne tension, qui comprend une enceinte étanche dans laquelle se trouvent des composants électriques ainsi qu'un milieu gazeux assurant l'isolation électrique et/ou l'extinction des arcs électriques au sein de cette enveloppe, ce milieu gazeux comprenant au moins une hydrofluorooléfine et une fluorocétone. Les caractéristiques du milieu gazeux sont telles que précédemment décrites à propos de son utilisation. L'appareil comprend de préférence un tamis moléculaire de $CaSO_4$.

Conformément à l'invention, cet appareil électrique peut être un transformateur électrique à isolation gazeuse comme, par exemple, un transformateur d'alimentation ou un transformateur de mesure. L'appareil électrique peut également être une ligne à isolation gazeuse, aérienne ou souterraine, ou un jeu de barres pour le transport ou la distribution de l'électricité. Enfin, il peut aussi être un appareil électrique de connexion/déconnexion (aussi appelé appareil de coupure) comme, par exemple, un disjoncteur, un interrupteur, un sectionneur, un combiné interrupteur-fusibles, un sectionneur de mise à la terre ou un contacteur.

**BRÈVE DESCRIPTION DES DESSINS**

D'autres avantages et caractéristiques ressortiront plus clairement de la description qui suit de modes particuliers de réalisation de l'invention, donnés à titre illustratif et nullement limitatifs, représentés dans les figures annexées.

Les figures 1A et 1B montrent la pression de vapeur saturante dans un mélange selon un mode de réalisation préféré de l'invention en fonction de la température : la figure 1A illustre l'évolution de la pression totale de gaz pour un mélange ternaire dont les proportions ont été définies par la loi de Raoult pour une apparition théorique de phase liquide à -25°C, la figure 1B pour une apparition théorique à -22°C.

La figure 2A représente une coupe longitudinale de l'appareil pour les essais de cheminement, dont les résultats sont synthétisés en figure 2B.

La figure 3A montre un dispositif dans lequel les tests de tenue diélectrique en ligne directe ont été réalisés avec un milieu gazeux selon l'invention, dont les résultats sont synthétisés en figure 3B.

La figure 4 synthétise les résultats obtenus durant des essais de décharges partielles.

La figure 5 synthétise les résultats obtenus durant des essais d'échauffement.

La figure 6 représente la pression de vapeur saturante de deux HFO et de C5K selon la température.

**EXPOSÉ DÉTAILLÉ DE MODES DE RÉALISATION PARTICULIERS**

L'invention est basée sur l'utilisation, avec ou sans gaz de dilution (gaz « tampon » comme $N_2$, $CO_2$, air,...), de fluorocétones à cinq atomes de carbone (C5K), et d'hydrofluorooléfines (HFO) à au moins trois atomes de carbone. Les C5K sont des cétones substituées par du fluor, ininflammables et de PRG très faible ; notamment les C5K utilisées ont pour formule brute $C_5F_{10}O$, et en particulier est sélectionnée la décafluoro-2-méthylbutan-3-one qui répond à la formule semi développée $CF_3-CO-CF-(CF_3)_2$, avec un potentiel de réchauffement global PRG = 1. Les C5K ne présentent pas de toxicité pour l'homme avec une valeur moyenne d'exposition VME (teneur limite moyenne à laquelle la majorité des travailleurs peut être exposée régulièrement à raison de 8 heures de travail pendant 5 jours par semaine, sans subir d'effet nocif) de 1000 ppm, et une dose létale $DL_{50}$ causant la mort de 50% d'une population animale supérieure à 200 000 ppm.

Les HFO sont des alcènes substitués par du fluor, de formule générale $C_n(H,F)_{2n}$ ; en particulier, les HFO utilisées comprennent 3 atomes de carbone ; elles sont ininflammables et leur PRG est inférieur à 10. Notamment l'hydrofluorooléfine HFO-1234ze, ou trans-1,3,3,3-tétrafluoro-1-propène, qui répond à la formule semi développée $CHF=CH-CF_3$, est utilisée pour les exemples comparatifs suivants. Son impact environnemental est PRG = 6, et elle ne présente pas de toxicité pour l'homme avec une VME = 1 000 ppm et une $DL_{50}$ > 200 000 ppm. Or dans la plupart des applications classiques à très basse température (-30°C, voire -40°C), HFO est diluée, parfois à moins de 20 %, dans un gaz vecteur neutre de type azote : le mélange n'est donc pas toxique. Les HFO-1234yf, ou 2,3,3,3-tétrafluoro-1-propène, et HFO-1225ye, ou 1,2,2,5-pentafluoro-1-propène, sont également envisagées pour le mélange selon l'invention.

Selon l'invention, le mélange de HFO et C5K est utilisé sous forme gazeuse quelle que soit la température d'utilisation de l'appareillage électrique. Il convient donc que la pression partielle de chacun de ces deux composants soit inférieure ou égale à la pression calculée selon la loi de Raoult. En effet, les molécules de fluorocétones et d'hydrofluorooléfines étant très proches de par leur composition, une limitation à leur pression de vapeur saturante pour une température d'utilisation donnée générerait une phase liquide à des températures supérieures à la température d'utilisation souhaitée du fait des interactions.

Selon l'appareillage, la pression interne du milieu d'isolation et/ou d'extinction d'arc qui est préconisée varie ; en particulier pour différentes raisons techniques, il est intéressant d'avoir une pression totale suffisamment importante, généralement strictement supérieure à $10^5$ Pa. Comme le mélange HFO/C5K est, selon l'invention, entièrement sous forme gazeuse à la température la plus basse de l'appareil électrique, pour remplir les conditions de pressions de remplissage données, un gaz de dilution, ou gaz tampon, est ajouté si besoin. De préférence, le gaz de dilution présente une température d'ébullition très basse, inférieure ou égale à la température minimale $T_{min}$ d'utilisation de l'appareil, et une rigidité diélectrique supérieure ou égale à celle du $CO_2$ ou de l'air dans des conditions d'essai identiques (même appareillage, même configuration géométrique, mêmes paramètres opératoires,...) à celles utilisées pour mesurer la rigidité diélectrique dudit gaz. Par ailleurs, selon l'invention, le gaz de dilution utilisé est un gaz à faible PRG de type air ou $CO_2$: ainsi, le milieu gazeux utilisé comme isolant et extincteur d'arc dans les appareils électriques a un PRG inférieur ou égal à celui de la HFO de référence. De préférence, pour les appareils à champ inhomogène, le dioxyde de carbone est utilisé ; alternativement, un gaz dilution de PRG nul, l'azote $N_2$, est utilisé.

Avantageusement, afin de maximiser la quantité de chacun des gaz fluorés constituant le mélange tout en ne générant pas de phase liquide à la température minimale d'utilisation de l'appareil pour un mélange ternaire fluorocétone C5K, hydrofluorooléfine HFO et gaz de dilution, les pressions de chaque constituant seront donc définies par la formule suivante issue de la loi de Raoult ($P_X$ étant la pression du gaz concerné et $PVS_X$ sa pression de vapeur saturante) :

$$P_{tot} = \frac{P_{HFO} + P_{C5K}}{\dfrac{P_{HFO}}{PVS_{HFO}} + \dfrac{P_{C5K}}{PVS_{C5K}}} + P_{gazdilution}$$

Par exemple, pour une température minimale d'utilisation $T_{min}$ = -25°C, plusieurs compositions de mélanges pourraient être utilisées pour remplir sans formation de liquide un appareillage électrique à enceinte étanche dont la pression totale de remplissage à 20°C est de 1,3 bar, c'est-à-dire $1,3 \cdot 10^5$ Pa, tel que présenté dans le tableau I ci-après.

**Tableau I :** proportions d'un mélange C5K + HFO-1234ze + $N_2$ à $1,3 \cdot 10^5$ Pa

| $P_{C5K}$ | $P_{HFO}$ | $P_{N2}$ |
|---|---|---|
| $0,15 \cdot 10^5$ Pa | $0,05 \cdot 10^5$ Pa | $1,10 \cdot 10^5$ Pa |
| $0,14 \cdot 10^5$ Pa | $0,12 \cdot 10^5$ Pa | $1,04 \cdot 10^5$ Pa |
| $0,13 \cdot 10^5$ Pa | $0,18 \cdot 10^5$ Pa | $0,99 \cdot 10^5$ Pa |
| $0,12 \cdot 10^5$ Pa | $0,25 \cdot 10^5$ Pa | $0,93 \cdot 10^5$ Pa |
| $0,11 \cdot 10^5$ Pa | $0,31 \cdot 10^5$ Pa | $0,88 \cdot 10^5$ Pa |
| $0,10 \cdot 10^5$ Pa | $0,37 \cdot 10^5$ Pa | $0,83 \cdot 10^5$ Pa |
| $0,09 \cdot 10^5$ Pa | $0,43 \cdot 10^5$ Pa | $0,78 \cdot 10^5$ Pa |
| $0,08 \cdot 10^5$ Pa | $0,49 \cdot 10^5$ Pa | $0,73 \cdot 10^5$ Pa |
| $0,07 \cdot 10^5$ Pa | $0,55 \cdot 10^5$ Pa | $0,68 \cdot 10^5$ Pa |
| $0,06 \cdot 10^5$ Pa | $0,62 \cdot 10^5$ Pa | $0,62 \cdot 10^5$ Pa |
| $0,05 \cdot 10^5$ Pa | $0,68 \cdot 10^5$ Pa | $0,57 \cdot 10^5$ Pa |
| $0,04 \cdot 10^5$ Pa | $0,74 \cdot 10^5$ Pa | $0,52 \cdot 10^5$ Pa |
| $0,03 \cdot 10^5$ Pa | $0,8 \cdot 10^5$ Pa | $0,47 \cdot 10^5$ Pa |
| $0,02 \cdot 10^5$ Pa | $0,86 \cdot 10^5$ Pa | $0,42 \cdot 10^5$ Pa |
| $10^3$ Pa | $0,92 \cdot 10^5$ Pa | $0,37 \cdot 10^5$ Pa |
| $10^2$ Pa | $0,98 \cdot 10^5$ Pa | $0,319 \cdot 10^5$ Pa |

Il apparaît cependant, en remplissant une enceinte équipée d'un hublot transparent avec un tel mélange, qu'il n'y a apparition pour ces mélanges d'une phase liquide que pour une température inférieure ou égale à -28°C : la loi de Raoult ne s'applique donc pas totalement.

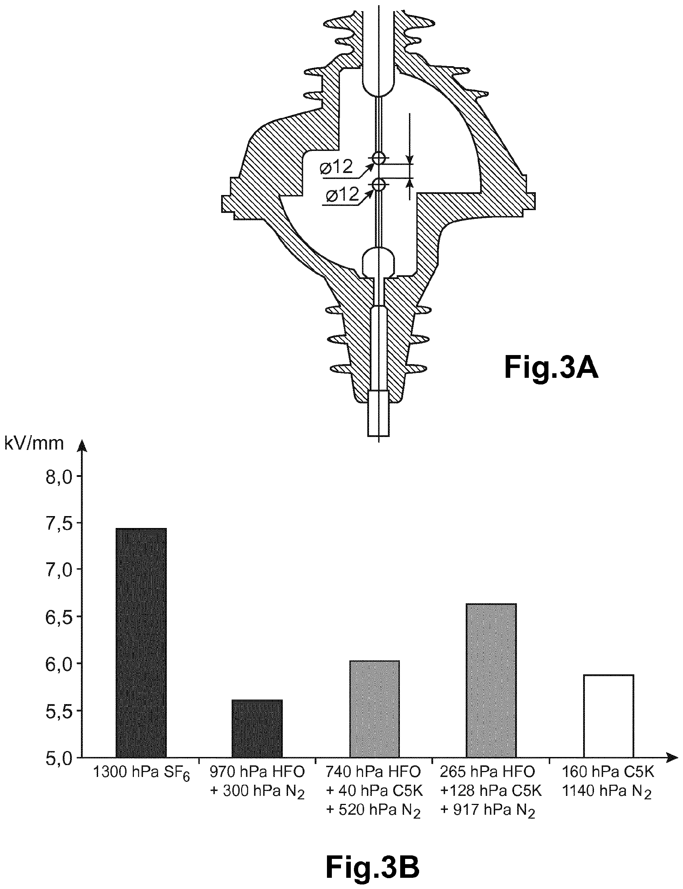

Or la rigidité diélectrique de chacun des deux composés fluorés utilisés dans le mélange, HFO pur et C5K pur, est meilleure que celle des gaz de dilution (voir aussi figure 3B). Aussi, pour augmenter les propriétés diélectriques du mélange qui dérivent directement de sa composition molaire, selon un mode de réalisation préféré de l'invention, le mélange est optimisé pour comprendre plus de composé fluoré que la valeur théorique ci-dessus ; avantageusement, on augmente la composition théorique par un ajout de C5K pour améliorer les propriétés diélectriques du mélange gazeux, notamment en cheminement, dans des proportions telles qu'il n'y a pas d'apparition de phase liquide.

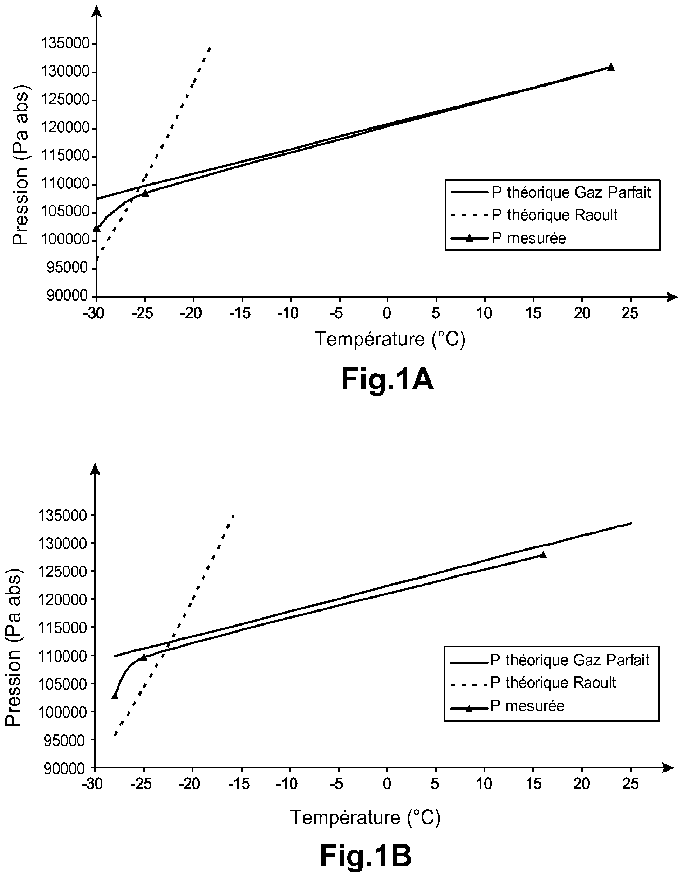

En particulier, tel qu'illustré en figure 1A, un mélange comprenant 40 hPa de C5K, 740·hPa de HFO-1234ze et 520 hPa d'azote suit, à température élevée, plus ou moins la courbe définie par la loi des gaz parfaits; il en diverge à température basse, notamment inférieure à -28°C (et parfois avant en raison des limites d'utilisation des appareils de test à -20°C par exemple), correspondant au croisement avec la courbe illustrant le comportement de ce mélange selon la loi de Raoult. De fait, aux températures les plus faibles, respecter les valeurs données par la loi de Raoult est plus conservateur et permet de s'assurer de la non-apparition d'une phase liquide, zone en dessous de la courbe de Raoult.

Ainsi, en figure 1B est illustré le comportement du mélange précédent dans lequel 20 hPa de C5K ont été ajoutés; bien entendu, la courbe est décalée d'autant en dessous de la courbe des gaz parfaits aux températures élevées. Si, théoriquement, l'apparition de liquide devait se produire à -22°C, expérimentalement (voir aussi le décrochement de la courbe réelle), la formation de liquide intervient en dessous de -25°C.

Selon un mode de réalisation préféré de l'invention, la composition en chacun des composants du mélange ternaire est déterminée par la loi de Raoult pour qu'il n'y ait pas apparition de phase liquide à une température que l'on peut prendre égale à la température minimale de fonctionnement de l'appareil ou un peu plus, par exemple à ladite température minimale moins 10%, ou de préférence à la température minimale prévue d'utilisation augmentée de 3°C.

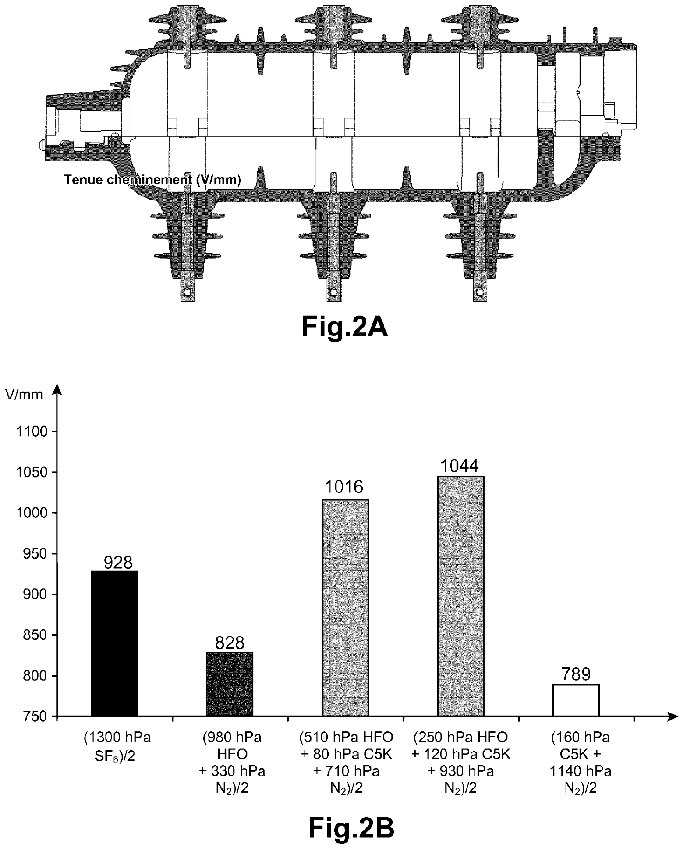

Le milieu gazeux selon l'invention remplit les conditions d'utilisation des appareillages actuels et ses propriétés sont supérieures aux mélanges binaires de chaque gaz fluoré, voire même du $SF_6$, avec effet synergique entre les deux molécules d'hydrofluorooléfine et de fluorocétone. Notamment, des essais de tenue en cheminement ont été réalisés dans un appareil à 1,3 ÷ 2 bars (c'est-à-dire 1300 ÷ 2 hPa) illustré en figure 2A, entre deux électrodes distantes de 251 mm, avec des conducteurs en cuivre et une résine époxyde chargée en silice comme isolant. Tel que présenté en figure 2B, on note que les mélanges ternaires constitués de HFO, de C5K et d'un gaz de dilution selon l'invention possèdent une meilleure tenue en cheminement que le $SF_6$ (plus de 1 000 V/mm comparés à moins de 930 V/mm) sur de l'époxyde chargé en silice et que les mélanges binaires de chacun des composants (ces constituants pris isolément ayant des propriétés plus faibles que le $SF_6$).

De façon similaire, les essais de tenue diélectrique en ligne directe à 1,3 bar (c'est-à-dire 1300 hPa) montrent que les performances du mélange selon l'invention sont supérieures à celle des composants individuels associés uniquement à un gaz de dilution : la figure 3A illustre l'enceinte époxyde remplie de 1,3 bar (soit 1300 hPa) de $SF_6$ ou d'un mélange de $N_2$ avec HFO et/ou C5K pour mesurer la tenue diélectrique entre deux contacts de rayon de 12 mm, distants de 12 mm. Un effet synergique entre HFO et C5K est notable pour la tenue diélectrique mesurée : figure 3B.

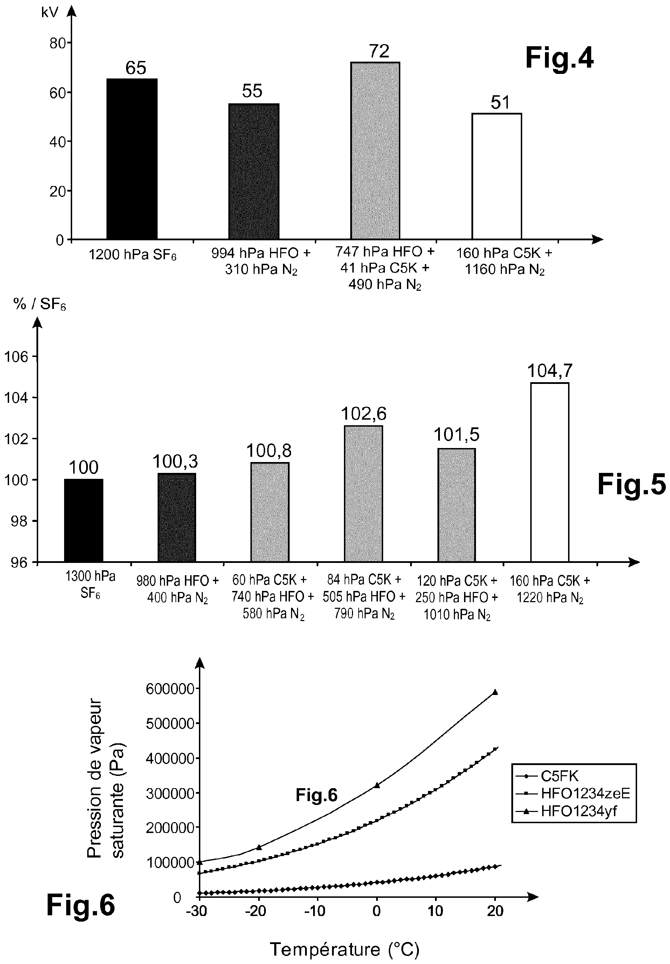

L'avantage d'un mélange ternaire selon l'invention comparé à un mélange binaire est également visible pour les décharges partielles (figure 4) : le seuil d'extinction est même supérieur à celui aux 65 kV du $SF_6$ pour le mélange ternaire, alors qu'il lui était inférieur pour les mélanges binaires.

Au vu des performances du mélange fluoré selon l'invention, seul ou avec un gaz de dilution simple de type air ou azote, une utilisation dans un appareillage existant peut être envisagée. En particulier, après avoir fait le vide (0 à 0,1 kPa) à l'aide d'une pompe à vide à huile, on peut remplir un appareil commercial moyenne tension de type GIS (appareil FBX 24 kV de Schneider Electric par exemple, rempli dans sa version commerciale actuelle, de $SF_6$ à une pression de 1300 hPa) conçu pour une application -25°C avec un mélange de gaz C5K, HFO-1234ze et de $CO_2$, préféré dans ce cas où les champs électriques ne sont pas homogènes. Par ailleurs, pour éviter les amorçages entre les dérivations, il est avantageux de les gainer par une gaine thermorétractable.

La pression totale de gaz à l'intérieur de l'appareil avec le mélange selon l'invention est choisie également à 1,3 bar ($P_{tot}$ = 1300 hPa) pour 20°C, et le mélange respecte les conditions définies par la loi de Raoult, par exemple avec une pression partielle comprise entre 80 et 120 hPa pour la C5K dans la mesure du possible. Au vu de la taille de l'enceinte de cet appareil (volume supérieur à 100 litres), il est préférable, pour accélérer l'homogénéisation du mélange gazeux d'utiliser des bulleurs ; cette option n'est bien entendu pas obligatoire, notamment dans le cas d'appareillages plus petits ou de délai suffisant avant expérimentation.

Par ailleurs, comme outre l'amélioration de la tenue diélectrique en ligne directe, les fluorocétones permettent d'améliorer la tenue diélectrique en cheminement du système, il est préférable de l'adsorber sur les parois des isolants. Dans un premier temps, pour tapisser les parois internes de l'appareil en C5K, ce composé est injecté pur dans l'enceinte, par exemple entre 3·et 10 hPa ; avantageusement entre 80 et 120 hPa de C5K, de préférence à une température supérieure à la température ambiante afin d'accélérer le débit (par exemple, le réservoir contenant le C5K peut être chauffé), sont injectés par l'intermédiaire de la sortie « gaz » de l'appareil. Après cette première étape permettant d'adsorber la fluorocétone sur les parois, le remplissage de l'appareil s'effectue à l'aide d'un mélangeur de gaz avec double bulleur permettant de contrôler le rapport entre C5K, HFO-1234ze et $CO_2$, ce rapport étant maintenu constant en pression à 20°C tout au long du remplissage grâce à l'utilisation d'un débitmètre massique de précision ; par exemple, C5K est placée dans les deux bulleurs qui sont traversés par le $CO_2$ et l'hydrofluorooléfine sous pression afin d'atteindre la pleine saturation.

Les essais sur ce type d'appareil traversé par un courant permanent de 630 A RMS ont montré que l'échauffement au niveau des contacts électriques (points les plus chauds) est très proche du $SF_6$ pour le mélange ternaire selon l'invention (comme pour les mélanges binaires) : voir figure 5, qui donne les résultats en variation de l'échauffement par rapport au $SF_6$.

Il est à noter par ailleurs que les appareils seront de préférence équipés d'un ou plusieurs tamis moléculaires de type sulfate de calcium ($CaSO_4$) anhydre, qui adsorbent les petites molécules créées lors de la coupure. La toxicité du gaz n'est donc pas augmentée après décharges partielles par des molécules pouvant présenter une toxicité.

De plus, en fin de vie ou après essais de coupure, le gaz est récupéré par les techniques classiques de récupération utilisant un compresseur et une pompe à vide. L'hydrofluorooléfine HFO-1234ze et la fluorocétone C5K sont alors séparées du gaz tampon en utilisant une zéolithe capable de piéger uniquement le gaz tampon, de taille inférieure ; alternativement, une membrane à séparation sélective laisse s'échapper l'azote et/ou le $CO_2$ et/ou l'air et garde C5K et HFO-1234ze dont la taille et la masse molaire sont plus importantes ; toute autre option est envisageable.

Bien que les exemples ci-dessus aient été réalisés avec HFO-1234ze, des alternatives à ce gaz sont possibles. En particulier, l'isomère HFO-1234yf (2,3,3,3-tétrafluoro-1-propène) peut être utilisé, avec les adaptations inhérentes aux propriétés de ce gaz : en particulier, tel qu'illustré en figure 6, comme sa température d'ébullition est de -30°C (contre -19°C pour HFO-1234ze), il est possible pour la même température de fonctionnement de -30°C de mettre 50 % de plus de HFO-1234yf que de HFO-1234ze. Comme pour une pression de remplissage donnée, plus il y a de HFO, et par conséquent moins il y a de gaz tampon, et que les propriétés d'isolation et d'extinction d'arc dépendent du mélange, la rigidité diélectrique est augmentée.

La solution selon l'invention permet ainsi de proposer un mélange gazeux à faible impact environnemental (PRG diminué de plus de 99,9 % par rapport à une isolation au $SF_6$) compatible avec les températures d'utilisation minimales de l'appareillage électrique et ayant des propriétés diélectrique, de coupure et de dissipation thermique proches de celles obtenues sur les appareils existants. Ce mélange peut directement remplacer le $SF_6$ utilisé dans les appareils, sans modifier ou presque leur conception : les lignes de production peuvent être gardées, avec simple changement du gaz de remplissage et éventuellement avec un ajout de systèmes d'aide à la coupure ou de matériaux gazogènes.

## REFERENCES CITEES

[1]   EP 1 724 802
[2]   WO 2008/073790
[3]   WO 2009/049144
[4]   DE 20 2009 009 305 U1

## Revendications

1.   Utilisation d'un milieu gazeux comprenant une hydrofluorooléfine à trois atomes de carbone et une fluorocétone à cinq atomes de carbone, comme milieu d'isolation électrique et/ou d'extinction des arcs électriques dans des appareils électriques de sous-station de moyenne tension.

2.   Utilisation d'un milieu selon la revendication 1, dans laquelle l'hydrofluorooléfine est le *trans*-1,3,3,3-tétrafluoro-1-propène (HFO-1234ze), le 2,3,3,3-tétrafluoro-1-propène (HFO-1234yf), ou le 1,2,2,5-pentafluoro-1-propène (HFO-1225ye).

3.   Utilisation d'un mélange selon la revendication 1 ou la revendication 2, dans laquelle la fluorocétone est la décafluoro-2-méthylbutan-3-one.

4.   Utilisation selon l'une des revendications 1 à 3, dans laquelle le milieu gazeux comprend en outre un gaz de dilution.

5.   Utilisation selon la revendication 4, dans laquelle le gaz de dilution est choisi parmi l'air, l'azote, l'oxygène, le dioxyde de carbone ou un mélange de ces gaz.

6.   Utilisation selon l'une des revendications 1 à 5, dans laquelle les pressions partielles de la fluorocétone et de l'hydrofluorooléfine au sein du mélange sont choisies en fonction de la température minimale de l'appareillage de manière à ne pas créer de phase liquide selon la loi de Raoult à une température de 3°C inférieure à la température minimale d'utilisation de l'appareil.

7.   Utilisation selon la revendication 6, dans laquelle la pression partielle de fluorocétone est comprise entre 80 et 120 hPa.

8.   Utilisation selon la revendication 6 ou la revendication 7, dans laquelle la température minimale ($T_{min}$) est choisie parmi -40°C, -35°C, -30°C, -25°C, -20°C, -15°C, -10°C, -5°C et 0°C.

9.   Appareil électrique moyenne tension, comprenant une enceinte étanche dans laquelle se trouvent des composants électriques ainsi qu'un milieu gazeux assurant l'isolation électrique et/ou l'extinction des arcs électriques susceptibles de se produire au sein de cette enceinte, **caractérisé en ce que** le milieu gazeux comprend une hydrofluorooléfine à trois atomes de carbone et une fluorocétone à cinq atomes de carbone.

10.   Appareil électrique selon la revendication 9, dans lequel l'hydrofluorooléfine est le *trans*-1,3,3,3-tétrafluoro-1-propène (HFO-12134ze) ou le 2,3,3,3-tétrafluoro-1-propène (HFO-1234yf) ou le 1,2,2,5-pentafluoro-1-propène (HFO-1225ye), et la fluorocétone est la décafluoro-2-méthylbutan-3-one.

11.   Appareil électrique selon la revendication 9 ou la revendication 10, dans lequel le milieu gazeux comprend en outre un gaz de dilution.

12.   Appareil électrique selon la revendication 11, dans lequel le gaz de dilution est choisi parmi l'air, l'azote, l'oxygène, le dioxyde de carbone ou un mélange de ces gaz.

13.   Appareil électrique selon l'une des revendications 9 à 12, dans lequel l'hydrofluorooléfine et la fluorocétone sont présentes dans le milieu avec des proportions définies selon la loi de Raoult pour ne pas créer de phase liquide à une température de 3°C inférieure à la température minimale d'utilisation de l'appareil.

14.   Appareil électrique selon l'une des revendications 9 à 13, qui est un transformateur électrique à isolation gazeuse, une ligne à isolation gazeuse pour le transport ou la distribution de l'électricité ou un appareil électrique de connexion/déconnexion.

15.   Appareil électrique selon l'une des revendications 9 à 14, qui comprend un tamis moléculaire de $CaSO_4$.

## Patentansprüche

1.   Verwendung eines gasförmigen Mediums, das ein Hydrofluorolefin mit drei Kohlenstoffatomen und ein Fluorketon mit fünf Kohlenstoffatomen enthält, als Medium zur elektrischen Isolierung und/oder Lichtbogenlöschung in elektrischen Vorrichtungen von Mittelspannungs-Unterwerken.

2. Verwendung eines Mediums nach Anspruch 1, wobei das Hydrofluorolefin *trans*-1,3,3,3-Tetrafluor-1-propen (HFO-1234ze), 2,3,3,3-Tetrafluor-1-propen (HFO-1234yf) oder 1,2,2,5-Pentafluor-1-propen (HFO-1225ye) ist.

3. Verwendung eines Gemisches nach Anspruch 1 oder Anspruch 2, wobei das Fluorketon Dekafluor-2-methylbutan-3-on ist.

4. Verwendung nach einem der Ansprüche 1 bis 3, wobei das gasförmige Medium ferner ein Verdünnungsgas enthält.

5. Verwendung nach Anspruch 4, wobei das Verdünnungsgas ausgewählt ist aus Luft, Stickstoff, Sauerstoff, Kohlendioxid oder einem Gemisch aus diesen Gasen.

6. Verwendung nach einem der Ansprüche 1 bis 5, wobei die Partialdruckwerte von Fluorketon und Hydrofluorolefin in dem Gemisch in Abhängigkeit von der Mindesttemperatur der Einrichtung so gewählt sind, dass keine Flüssigphase nach dem Raoult'schen Gesetz bei einer um 3 °C geringeren Temperatur als die minimale Verwendungstemperatur der Vorrichtung geschaffen wird.

7. Verwendung nach Anspruch 6, wobei der Partialdruck von Fluorketon zwischen 80 und 120 hPa beträgt.

8. Verwendung nach Anspruch 6 oder Anspruch 7, wobei die Mindesttemperatur ($T_{min}$) ausgewählt ist aus -40 °C, -35 °C, -30 °C, -25 °C, -20 °C, -15 °C, -10 °C, -5 °C und 0 °C.

9. Elektrische Mittelspannungs-Vorrichtung, enthaltend ein dichtes Gehäuse, in welchem elektrische Komponenten sowie ein gasförmiges Medium enthalten sind, das die elektrische Isolierung und/oder Löschung von Lichtbögen sicherstellt, die in diesem Gehäuse auftreten können, **dadurch gekennzeichnet, dass** das gasförmige Medium ein Hydrofluorolefin mit drei Kohlenstoffatomen und ein Fluorketon mit fünf Kohlenstoffatomen enthält.

10. Elektrische Vorrichtung nach Anspruch 9, wobei das Hydrofluorolefin *trans*-1,3,3,3-Tetrafluor-1-propen (HFO-12134ze) oder 2,3,3,3-Tetrafluor-1-propen (HFO-1234yf) oder 1,2,2,5-Pentafluor-1-propen (HFO-1225ye) ist und das Fluorketon Dekafluor-2-methylbutan-3-on ist.

11. Elektrische Vorrichtung nach Anspruch 9 oder Anspruch 10, wobei das gasförmige Medium ferner ein Verdünnungsgas enthält.

12. Elektrische Vorrichtung nach Anspruch 11, wobei das Verdünnungsgas ausgewählt ist aus Luft, Stickstoff, Sauerstoff, Kohlendioxid oder einem Gemisch aus diesen Gasen.

13. Elektrische Vorrichtung nach einem der Ansprüche 9 bis 12, wobei Hydrofluorolefin und Fluorketon in dem Medium in Anteilen vorhanden sind, die nach dem Raoult'schen Gesetz definiert sind, um nicht bei einer um 3 °C geringeren Temperatur als die minimale Verwendungstemperatur der Vorrichtung eine Flüssigphase zu schaffen.

14. Elektrische Vorrichtung nach einem der Ansprüche 9 bis 13, bei der es sich um einen elektrischen Transformator mit Gasisolierung, eine gasisolierte Leitung zur Weiterleitung bzw. Verteilung von Elektrizität oder um eine elektrische Einschalt-/Ausschaltvorrichtung handelt.

15. Elektrische Vorrichtung nach einem der Ansprüche 9 bis 14, die ein Molekularsieb aus $CaSO_4$ enthält.

**Claims**

1. Use of a gaseous medium comprising a hydrofluoroolefin with three carbon atoms and a fluoroketone with five carbon atoms, as an electric insulating and/or electric arc extinguishing medium in substation medium-voltage electrical devices.

2. Use of a medium according to claim 1, in which the hydrofluoroolefin is *trans*-1,3,3,3-tetrafluoro-1-propene (HFO-1234ze), 2,3,3,3-tetrafluoro-1-propene (HFO-1234yf), or 1,2,2,5-pentafluoro-1-propene (HFO-1225ye).

3. Use of a mixture according to claim 1 or claim 2, in which the fluoroketone is decafluoro-2-methylbutan-3-one.

4. Use according to one of claims 1 to 3, in which the gaseous medium further comprises a dilution gas.

5. Use according to claim 4, in which the dilution gas is chosen from air, nitrogen, oxygen, carbon dioxide or a mixture of these gases.

6. Use according to one of claims 1 to 5, in which the partial pressures of the fluoroketone and hydrofluoroolefin within the mixture are chosen as a function of the minimum temperature of the device so as not to create a liquid phase according to Raoult's law at a temperature of 3°C below the minimum service temperature of the device.

7. Use according to claim 6, in which the partial pressure of fluoroketone is comprised between 80 and 120 hPa.

8. Use according to claim 6 or claim 7, in which the minimum temperature ($T_{min}$) is chosen from -40°C, -35°C, -30°C, -25°C, -20°C, -15°C, -10°C, -5°C and 0°C.

9. Medium-voltage electrical device, comprising a sealed enclosure in which electrical components are located together with a gaseous medium providing electric insulating and/or extinguishing of electric arcs likely to occur within said enclosure, **characterised in that** the gaseous medium comprises a hydrofluoroolefin with three carbon atoms and a fluoroketone with five carbon atoms.

10. Electrical device according to claim 9, in which the hydrofluoroolefin is *trans*-1,3,3,3-tetrafluoro-1-propene (HFO-1234ze) or 2,3,3,3-tetrafluoro-1-propene (HFO-1234yf) or 1,2,2,5-pentafluoro-1-propene (HFO-1225ye), and the fluoroketone is decafluoro-2-methylbutan-3-one.

11. Electrical device according to claim 9 or claim 10, in which the gaseous medium further comprises a dilution gas.

12. Electrical device according to claim 11, in which the dilution gas is chosen from air, nitrogen, oxygen, carbon dioxide or a mixture of these gases.

13. Electrical device according to one of claims 9 to 12, in which the hydrofluoroolefin and the fluoroketone are present in the medium with proportions defined according to Raoult's law so as not to create a liquid phase at a temperature of 3°C below the minimum service temperature of the device.

14. Electrical device according to one of claims 9 to 13, which is a gas-insulated electrical transformer, a gas-insulated line for transporting or distributing electricity or an electrical connection/disconnection device.

15. Electrical device according to one of claims 9 to 14, which comprises a $CaSO_4$ molecular sieve.

**Fig.1A**

**Fig.1B**

**Fig.2A**

**Fig.2B**

**Fig.3A**

**Fig.3B**

kV

80 –

65

72 **Fig.4**

55

60 –

51

40 –

20 –

0 –

| 1200 hPa SF₆ | 994 hPa HFO + 310 hPa N₂ | 747 hPa HFO + 41 hPa C5K + 490 hPa N₂ | 160 hPa C5K + 1160 hPa N₂ |

% / SF₆

106 –

104,7

104 –

102,6

102 –

101,5

100,8

100 100,3

100 –

98 –

96 –

| 1300 hPa SF₆ | 980 hPa HFO + 400 hPa N₂ | 60 hPa C5K + 740 hPa HFO + 580 hPa N₂ | 84 hPa C5K + 505 hPa HFO + 790 hPa N₂ | 120 hPa C5K + 250 hPa HFO + 1010 hPa N₂ | 160 hPa C5K + 1220 hPa N₂ |

**Fig.5**

Pression de vapeur saturante (Pa)

600000 –

500000 –

400000 –

**Fig.6**

300000 –

200000 –

100000 –

0 –

| -30 | -20 | -10 | 0 | 10 | 20 |

Température (°C)

| C5FK |
| HFO1234zeE |
| HFO1234yf |

**Fig.6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1724802 A
- WO 2008073790 A
- WO 2009049144 A
- DE 202009009305 U1